# EUROPÄISCHE PATENTSCHRIFT

(11) **EP 0 656 310 B1**
(45) Veröffentlichungstag und Bekanntmachung des Hinweises auf die Patenterteilung: **12.08.1998**
(21) Anmeldenummer: 94115906.3
(22) Anmeldetag: 08.10.1994
(51) Int. Cl.: B65H 39/16

(54) **Verfahren und Vorrichtung zur Herstellung eines Folienverbundes**
Method and apparatus for producing a laminate
Procédé et dispositif pour produire un stratifié

(30) Priorität: 02.04.1994 DE 4411618; 02.12.1993 DE 4340996
(43) Veröffentlichungstag der Anmeldung: 07.06.1995
(73) Patentinhaber: W.C. Heraeus GmbH, D-63450 Hanau (DE)
(72) Erfinder: Herklotz, Günter, Dr., D-63486 Bruchköbel (DE); Ullrich, Karl-Heinz, Dr., D-64823 Gross-Umstadt (DE); Loose, Thomas, D-63594 Hasselroth (DE); Lach, Friedrich, D-63594 Hasselroth (DE); Hartmann, Horst, D-63454 Hanau (DE); Bauer, Alfred, D-63755 Alzenau (DE)
(74) Vertreter: Kühn, Hans-Christian

(56) Entgegenhaltungen:
- WO-A-92/15118
- GB-A- 2 031 796

## Beschreibung

Die Erfindung betrifft ein Verfahren zur Herstellung eines eine Metallfolienbahn und eine zweite Folienbahn enthaltenden Folienverbundes, bei dem die beiden Folienbahnen jeweils sich in Längsrichtung der Folienbahnen in gleichmäßigen Abständen wiederholende und an aneinanderliegenden Stellen im Folienverbund angeordnete Stanzstrukturen aufweisen, wobei eine vorgestanzte Folienbahn und die zweite Folienbahn von jeweils einem Ende her fortlaufend zusammengefügt werden, wobei nach dem Aneinanderführen der Folienbahnen die Lage von Positionsmarkierungen der an der zweiten Folienbahn anliegenden Stanzstrukturen der vorgestanzten Folienbahn nacheinander abgetastet wird und nach Erreichen einer vorbestimmten Position der Positionsmarkierungen eine Stanzstruktur in den vor dem Ort des Aneinanderführens gelegenen Bereich der zweiten Folienbahn in einem Abstand von der vorbestimmten Position eingebracht wird, der einem ganzzahlig Vielfachen des Abstandes entspricht, in dem sich die Stanzstrukturen in der vorgestanzten Folienbahn wiederholen. Die Erfindung betrifft weiterhin eine Vorrichtung zur Herstellung eines eine Metallfolienbahn und eine Kunststoff-Folienbahn aufweisenden Folienverbundes mit sich in gleichmäßigen Abständen wiederholenden Stanzstrukturen, die eine Vorschub- und Führungseinrichtung für den Folienverbund, eine Fügevorrichtung zum festen Verbinden der beiden Folienbahnen und Vorschub- und Führungseinrichtungen für das Aneinanderführen und das Zusammenfügen der beiden Folienbahnen aufweist.

Derartige Verfahren sind aus GB 2 031 796 A bekannt. In dieser Veröffentlichung wird beschrieben, daß eine Metall-Folienbahn und eine nichtleitende Folienbahn zusammengefügt werden, wobei die relative Lage unterschiedlicher Strukturen überprüft und mit einem Soll-Wert verglichen wird. Bei Abweichung der relativen Lage vom Soll-Wert wird ein Ausgleich bzw. eine Korrektur dadurch erreicht, daß die Zuführgeschwindigkeit für die nicht leitende Folie entsprechend geändert wird. Als Vergleichsstrukturen werden separate Positionsmarkierungen des Metallbandes verwendet sowie die in das nichtleitende Folienband eingebrachten Strukturen, deren Form entsprechend der Form der beabsichtigten elektronischen Komponente ausgebildet ist. Da diese Form in der Regel relativ kompliziert ist, ist eine exakte Positionserfassung, insbesondere bei größerem Versatz zwischen den beiden Folienbahnen, kaum möglich.

Aus der WO-92/15118 ist es bekannt, zwei Folienbahnen, die Stanzmarkierungen aufweisen, derart aufeinander zu bringen, daß die Stanzmarkierungen der einen Folienbahn an der gleichen Stelle des Folienverbundes angeordnet sind, wie die Stanzmarkierungen der zweiten Folienbahn. Dazu wird die Lage der Stanzmarkierungen überwacht und ein evtl. Versatz zwischen den Stanzmarkierungen wird dadurch ausgeglichen, daß die Größe dieses Versatzes gemessen wird und entsprechend dieser Größe die beiden Folienbahnen vor dem Zusammenfügen mit einer unterschiedlichen Temperatur beaufschlagt werden, um durch die dadurch bewirkte unterschiedliche Ausdehnung der beiden Folienbahnen den Versatz auszugleichen. Zusätzlich kann die eine Folienbahn mit einer Zugspannung beaufschlagt werden, so daß die dadurch erzeugte Dehnung dieser Folienbahn zum Ausgleich des Versatzes beiträgt. Ein derartiges Verfahren erfordert einen hohen apparativen Aufwand, um die unterschiedliche Temperaturbeaufschlagung der beiden Folienbahnen zu realisieren und um zu gewährleisten, daß die erforderlichen Temperaturänderungen in einer sehr kurzen Zeit erfolgen können, um den Abschnitt des Folienverbundes, der diesen Versatz aufweist, möglichst klein halten zu können. Der für eine solche Regelung über Temperaturänderungen bzw. über Zugspannungen benötigte Regelkreis ist sehr kompliziert und in der Regel reaktionsträge. Des weiteren ist es problematisch, zwei Folien unter derartigen Ausgangsbedingungen fest miteinander zu verbinden, da nach Wegfall der Zugkraft bzw. nach Angleichen der Temperaturen der beiden Folienbahnen in diesem Folienverbund thermomechanische Spannungen zwischen den beiden Folienbahnen auftreten dürften, die dazu führen können, daß sich der Folienverbund verformt oder daß sich die beiden Folienbahnen voneinander lösen.

Des weiteren ist das sogenannte TAB-Verfahren (Tape Automatic Bonding) bekannt. Dabei wird eine Kunststoff-Folienbahn als vorgestanzte Trägerfolie benutzt, auf die eine Metallfolie aufgebracht wird. Die Metallstruktur wird anschließend durch chemisches Ätzen erzeugt.

Abgeleitet aus dem vorstehend beschriebenen Stand der Technik besteht die Aufgabe der vorliegenden Erfindung darin, ein Verfahren anzugeben, mit dem ein gestanztes Kunststoff-Folienband mit einem gestanzten Metallfolienband derart zusammen laminiert werden kann, daß mit einem möglichst geringen Aufwand der Versatz zwischen den Strukturen der beiden Folienbänder möglichst gering gehalten wird. Die Aufgabe der vorliegenden Erfindung besteht weiterhin darin, eine Vorrichtung zur Durchführung dieses Verfahrens anzugeben.

Erfindungsgemäß wird die Aufgabe für das eingangs charakterisierte Verfahren dadurch gelöst, daß die vorgestanzte Folienbahn aus Metall und die zweite Folienbahn aus Kunststoff ist und daß die Kunststoff-Folienbahn vor dem Zusammenfügen mindestens teilweise, nämlich in ihrem Anfangsbereich in einer Länge, die dem Abstand zwischen der Abtaststelle und dem Ort des Stanzens entspricht, vor dem Aneinanderführen der Folienbahnen mit Positionsmarkierungen versehen wird und daß beim Abtasten die Positionsmarkierungen der Folienbahnen übereinander angeordnet sind. Dies kann beispielsweise dadurch geschehen, daß dieses erste Teilstück der Kunststoff-Folienbahn in der gleichen Stanzeinrichtung, in der die Struktur der Metallfolienbahn gestanzt wird, mit den auch für die Metallfolienbahn verwendeten Markierungen versehen wird, die als Positionsmarkierungen, also als die Markierungen, die beim Zusammenbringen der Folienbahnen abgetastet werden, Verwendung finden. Durch das dadurch mögliche Abtasten einander entsprechender Positionsmarkierungen beider Folienbahnen kann bereits während des Abtastvorganges ein Versatz festgestellt werden, der durch eine Änderung des Ortes des Stanzens der Kunststoff-Folie ausgeglichen werden kann. Es ist jedoch auch denkbar, die Kunststoff-Folienbahn vorzustanzen. Bei diesem Verfahren wird die Position jeder Stanzstruktur in der Metallfolienbahn ermittelt und diese Position in einer Art Kopiervorgang auf die Kunststoff-Folienbahn übertragen, wobei die Stanzung der Kunststoff-Folienbahn in einem solchen Abstand erfolgt, daß die Stanzstrukturen der beiden Folienbahnen nach dem Zusammenfügen der Folienbahnen an der gleichen Stelle des Folienverbundes angeordnet sind. Der Versatz zwischen den Strukturen der Metallfolienbahn und der Kunststoff-Folienbahn wird dann lediglich noch bestimmt durch Toleranzen in dem Abstand zwischen der Abtaststelle und dem Ort des Stanzens der Kunststoff-Folie. Dieser Abstand läßt sich auf nur einige Vielfache des Abstandes verringern, in dem sich die Stanzstrukturen der Metallfolienbahn wiederholen. Dadurch und durch ein genaues Festlegen des Ortes des Stanzens der Kunststoff-Folienbahn läßt sich die Genauigkeit der Lage der Stanzstrukturen in der Kunststoff-Folienbahn nahezu beliebig erhöhen. Bei diesem Verfahren weist lediglich der Anfang der Kunststoff-Folienbahn, nämlich auf der Strecke zwischen der ersten Positionsmarkierung und dem Ort des Stanzens, keine Stanzstruktur auf, so daß lediglich das diesem ersten Stück entsprechende Teilstück des fertigen Folienverbundes verworfen werden muß.

Zweckmäßigerweise werden die Folienbahnen nach dem Abtasten miteinander verklebt , da dadurch die beiden, unterschiedliche thermische Ausdehnungskoeffizienten aufweisenden Folienbahnen erst nach dem Abtastvorgang erhitzt werden (das Verkleben erfolgt in der Regel zweckmäßigerweise unter Hitzeeinwirkung). Dadurch wird vermieden, daß die beiden Folienbahnen im Bereich des Abtastens bzw. zwischen dem Abtasten und dem Ort des Stanzens der Kunststoff-Folienbahn unterschiedlich ausgedehnt werden und dadurch Ungenauigkeiten beim Zusammenfügen der beiden Folienbahnen entstehen. Zweckmäßig ist es dabei, die Folienbahnen in einem ersten Schritt mittels einzelner kleinflächiger Klebepunkte aneinanderzuheften und danach in einem zweiten Schritt großflächig zu verkleben. Dadurch werden die Folien in ihrer Lage zueinander bei lediglich punktförmiger Aufheizung aneinander fixiert und erst danach in dem zweiten Klebeschritt großflächig erhitzt, so daß eine eventuell unterschiedliche Ausdehnung der beiden Folienbahnen während des Erhitzens nicht zu einem Verzug bzw. zu einer relativen Lageänderung der Stanzmarkierungen führt.

Die Genauigkeit des Zusammenfügens der beiden Folienbahnen kann dadurch weiter erhöht werden, daß nach dem Aneinanderführen der Folienbahnen die Stanzstrukturen der Folienbahnen optisch überwacht werden und daß bei Überschreiten einer vorbestimmten Abweichung der Lage der Stanzstrukturen der Kunststoff-Folienbahn von der Lage der Stanzstrukturen der Metallfolienbahn der Abstand zwischen der abgetasteten vorbestimmten Position und dem durch ein Stanzwerkzeug charakterisierten Ort des Stanzens der Kunststoff-Folienbahn korrigiert wird. Diese Korrektur kann manuell durch eine Bedienperson oder über eine automatische Regelung dadurch erfolgen, daß das Stanzwerkzeug um den Betrag des Versatzes in der entsprechenden Richtung verstellt wird. Dabei können sowohl Korrekturen in Laufrichtung der Folienbahnen als auch senkrecht dazu durchgeführt werden.

Zweckmäßig ist es, daß kreisförmige Positionsmarkierungen der Stanzstrukturen der Metallfolienbahn abgetastet und mit der Lage von vor dem Aneinanderführen der Folienbahn in die Kunststoff-Folienbahn eingebrachten Kreisstanzungen verglichen werden, deren Anordnung auf der Kunststoff-Folienbahn der Anordnung der kreisförmigen Positionsmarkierungen der Stanzstrukturen auf der Metallfolienbahn entspricht. Dabei kann zweckmäßig die Abtastung mittels eines Dorns erfolgen. Das Abtasten bzw. der Vergleich von kreisförmigen Strukturen ist wesentlich einfacher und führt zu eindeutigeren Ergebnissen, als dies bei der Abtastung anderer Formen möglich ist. Prinzipiell sind jedoch auch andere Formen, wie Rechtecke oder Dreiecke als Positionsmarkierungen möglich. Die Form des Dorns ist dabei vorteilhafterweise der Form der Positionsmarkierungen angepaßt.

Die der Erfindung zugrunde liegende Aufgabe wird für die eingangs charakterisierte Vorrichtung dadurch gelöst, daß hinter dem Ort des Aneinanderführens der beiden Folienbahnen eine Abtastvorrichtung zur Erfassung der Position der Stanzstruktur der vorgestanzten Folienbahn angeordnet ist und daß diese Abtastvorrichtung mit einem Auslöser eines vor dem Ort des Aneinanderführens der beiden Folienbahnen angeordneten Stanzwerkzeuges gekoppelt ist, wobei der Abstand der Abtastvorrichtung von dem Stanzwerkzeug einem ganzzahlig Vielfachen des Abstandes entspricht, in dem sich die Stanzstrukturen der vorgestanzten Folienbahn wiederholen. Die Lage der Stanzstruktur in der zweiten Folienbahn wird dabei bestimmt durch die Lage der Stanzstruktur in der vorgestanzten Folienbahn, so daß ein versatzfreies Aneinanderliegen in dem Folienverbund gewährleistet ist. Ein evtl. Versatz der beiden Folienbahnen kann frühzeitig festgestellt und durch Verstellen des Stanzwerkzeuges korrigiert werden.

Zweckmäßig ist es, daß die Abtastvorrichtung eine Vorschubeinrichtung beinhaltet, so daß der Abtastvorgang mit dem Vorschub gekoppelt werden kann.

Vorteilhaft ist es dabei, daß zwischen dem Ort des Aneinanderführens der beiden Folienbahnen und der Abtastvorrichtung ein Monitor zur optischen Kontrolle der Stanzstrukturen angeordnet ist. Der Monitor kann eine Einrichtung zur meßtechnischen Erfassung von Abweichungen zwischen der Lage der Stanzstrukturen der Metallfolienbahn und der Kunststoff-Folienbahn enthalten und bei Überschreiten einer festgelegten Toleranzgrenze einen Verstellmechanismus des Stanzwerkzeuges zur Nachregelung der Lage des Stanzwerkzeuges auslösen, so daß die am Monitor ermittelte Abweichung kompensiert werden kann. Dazu ist es zweckmäßig, daß das Stanzwerkzeug eine Justiereinrichtung aufweist, die eine Justierung des Stanzwerkzeuges in Laufrichtung der Folienbahnen oder/und quer dazu (x-und y-Richtung) ermöglicht, und daß der Monitor mit der Justiereinrichtung des Stanzwerkzeuges verbunden ist. Es ist auch möglich, die am Monitor gemessene Abweichung durch eine von Hand erfolgende Verstellung der Lage des Stanzwerkzeuges zu kompensieren.

Vorteilhaft ist es, daß die Abtastvorrichtung einen Dorn als Abtastelement enthält. Mittels eines solchen Dornes ist es auf relativ einfache Weise möglich, die Position der Stanzstrukturen zu erfassen.

Natürlich ist es ebenfalls möglich und soll von der Erfindung ausdrücklich umfaßt werden, daß die Stanzstrukturen nicht mit einem herkömmlichen Stanzwerkzeug, sondern auf andere Weise, beispielsweise mittels eines Laserstrahls in die Folienbahnen eingebracht werden.

Nachfolgend wird die Erfindung anhand eines Ausführungsbeispieles und einer Zeichnung näher erläutert. Die Zeichnung zeigt in
Figur 1 die ertindungsgemäße Vorrichtung einschließlich der Folienbahnführung in schematischer Darstellung.
Figur 2 das Aneinanderführen der Folienbahnen.

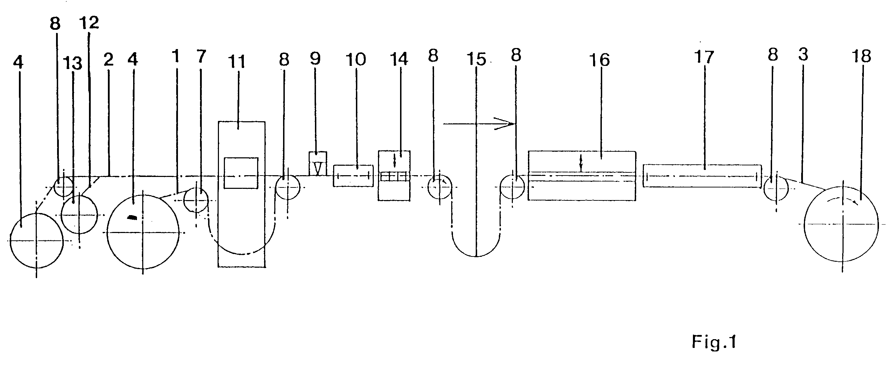

Metallfolienbahn 1 und Kunststoff-Folienbahn 2 werden zur Herstellung des Folienverbundes 3 der erfindungsgemäßen Vorrichtung getrennt zugeführt (Figur 1). Die Metallfolienbahn befindet sich auf einer Vorratsrolle 4. Sie ist bereits vorgestanzt, d. h. sie enthält bereits die ihr zugeordnete Stanzstruktur 5 einschließlich der jeder einzelnen Stanzstruktur 5 zugeordneten kreisförmigen Positionsmarkierung 6. Über eine Vorschubrolle 7 und eine Führungsrolle 8 wird die Metallfolienbahn 1 an einem Monitor 9 vorbei der Abtastvorrichtung 10 zugeführt. Die Abtastvorrichtung 10 dient gleichzeitig als Vorschubeinrichtung. Die Kunststoff-Folienbahn 2 befindet sich ebenfalls auf einer Vorratsrolle 4. Der Anfang der Kunststoff-Folienbahn 2 ist in dem Abstand, der dem Abstand zwischen der Abtastvorrichtung 10 und dem Stanzwerkzeug 11 entspricht, mit kreisförmigen Positionsmarkierungen 6 versehen, deren Lage auf der Kunststoff-Folienbahn 2 der Lage der kreisförmigen Positionsmarkierungen 6 auf der Metallfolienbahn 1 entspricht. Diese kreisförmigen Positionsmarkierungen 6 der Kunststoff-Folienbahn 2 sind mit der gleichen, in der Zeichnung nicht dargestellten Stanzvorrichtung hergestellt, in der die Stanzstrukturen 5 in die Metallfolienbahn 1 eingebracht wurden. Diese Stanzung in die KunststoffFolienbahn 2 erfolgte allerdings lediglich zu dem Zweck des Einbringens der kreisförmigen Positionsmarkierungen 6. Weitere Stanzstrukturen wurden dabei nicht eingebracht.

Die Kunststoff-Folienbahn 2 wird über Führungsrollen 8 an dem Stanzwerkzeug 11 und dem Monitor 9 vorbei ebenfalls der Abtastvorrichtung 10 zugeführt, durch die auch der Vorschub erfolgt. Die auf der Kunststoff-Folienbahn 2 ursprünglich vorhandene Schutzfolie 12 wird vor dem Durchgang der Kunststoff-Folienbahn 2 durch das Stanzwerkzeug 11 auf eine Entsorgungsrolle 13 aufgewickelt.

Kunststoff-Folienbahn 2 und Metallfolienbahn 1 werden beim Einbringen der beiden Folienbahnen in die Abtastvorrichtung 10 mit ihren Positionsmarkierungen 6 übereinander angeordnet. Mit Hilfe des Monitors 9 wird die Lage der beiden Folienbahnen kontrolliert und ein evtl. Versatz zwischen den beiden Folienbahnen festgestellt, so daß die Anordnung des Stanzwerkzeuges 11 gegebenenfalls nachjustiert werden kann. Das Stanzwerkzeug 11 ist ein ganzzahlig Vielfaches des Abstandes, in dem sich die Stanzstrukturen 5 auf der Metallfolienbahn 1 wiederholen, von der Abtastvorrichtung 10 entfernt angeordnet. Die Abtastvorrichtung 10 enthält einen aus Gründen der besseren Übersichtlichkeit in der Zeichnung nicht dargestellten Dorn als Abtastelement. Maßgebend für den Abstand zwischen Abtastvorrichtung 10 und Stanzwerkzeug 11 ist der Abstand zwischen dem Dorn und dem Stanzelement des Stanzwerkzeuges 11, das die kreisförmigen Positionsmarkierungen 6 in die Kunststoff-Folienbahn 2 stanzt. In dem dargestellten Beispiel wiederholen sich die Stanzstrukturen 5 der Folienbahnen in einem Abstand von etwa 57 mm. Der Abstand zwischen der Abtastvorrichtung 10 und dem Stanzwerkzeug 11 entspricht demzufolge einem ganzzahlig Vielfachen dieser Entfernung. Als günstig hat sich der etwa 8 - 12fache Abstand erwiesen. Durch das Abtasten der Folienbahnen in der Abtastvorrichtung 10 und die Kontrolle des Versatzes im Monitor 9 ist es möglich, den tatsächlich erzeugten Versatz auf ein Minimum zu begrenzen, da dieser Versatz im wesentlichen nur noch abhängig ist von der evtl. vorhandenen Ungenauigkeit der Anordnung des Stanzwerkzeuges 11. Da die Strecke zwischen dem Monitor 9 und dem Stanzwerkzeug 11 sehr gering gehalten werden kann (der Monitor 9 ist zwischen dem Stanzwerkzeug 11 und der Abtastvorrichtung 10 angeordnet), lassen sich die Ungenauigkeiten sehr schnell feststellen und entweder nach Kontrolle des Versatzes im Monitor 9 manuell korrigieren oder es ist auch möglich, den Monitor 9 in einem Regelkreis mit dem Stanzwerkzeug 11 zu koppeln und die evtl. notwendig werdende Nachjustierung des Stanzwerkzeuges 11 automatisch zu realisieren. Mit einer solchen Anordnung ist es möglich, den Versatz zwischen den einzelnen Stanzstrukturen 5 der beiden Folienbahnen auf weniger als 50 µm zu reduzieren.

Da sowohl die Vorratsrollen 4 als auch das Stanzwerkzeug 11, der Monitor 9 und die Abtastvorrichtung 10 in einem klimatisierten Raum angeordnet werden können, lassen sich durch Temperaturschwankungen bedingte Ungenauigkeiten vermeiden.

Bei dem Verfahren wird also die Lage von Positionsmarkierungen 6 in der Metallfolienbahn 1 festgestellt und entsprechend dieser Lage die Lage der Stanzung in der Kunststoff-Folienbahn 2 festgelegt.

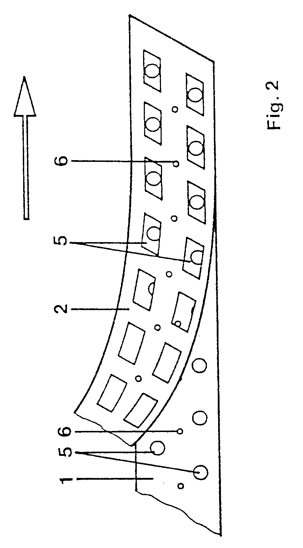

In Figur 2 ist das Aneinanderführen der beiden Folienbahnen dargestellt. Auf die Darstellung des nicht mit Stanzstrukturen 5 in der Kunststoff-Folienbahn 2 belegten Anfangs des Folienverbundes wurde dabei verzichtet. Die Stanzstrukturen 5 der beiden Folienbahnen werden bei dem Vorgang aneinandergelegt und der Versatz zwischen beiden wird mittels der Positionsmarkierungen 6, wie oben beschrieben, minimiert.

Nach dem Durchgang der Folienbahnen durch die Abtastvorrichtung 10 werden die Folienbahnen mittels der Vorschubeinrichtung der Abtastvorrichtung 10 der Fügevorrichtung 14 zugeführt, in der die beiden Folienbahnen in etwa 1 bis 2 Sekunden bei etwa 170°C aneinandergeheftet werden. Dabei werden die Folienbahnen durch in der Zeichnung nicht dargestellte Führungsstifte geführt, die in die kreisförmigen Positionsmarkierungen 6 der Folienbahnen eingreifen. Durch diese Führung mittels der Führungsstifte, zweckmäßigerweise erfolgt die Führung durch mindestens zwei Führungsstifte, wird verhindert, daß sich die Folienbahnen während des Zusammenfügens in ihrer Lage verziehen. Die in der Fügevorrichtung 14 aneinandergehefteten Folienbahnen werden über Führungsrollen 8 in einer lockeren Schleife 15 der Laminiervorrichtung 16 zugeführt, in der die beiden Folienbahnen in etwa 30 Sekunden bei etwa 180°C miteinander zu einem Folienverbund 3 fest verklebt werden. Beide Klebevorgänge verlaufen getaktet, die Führung der Folienbahnen in einer lockeren Schleife 15 zwischen der Fügevorrichtung 14 und der Laminiervorrichtung 16 kompensiert die unterschiedlichen Taktzeiten. Aus der Laminiervorrichtung 16 herauskommend wird der Folienverbund 3 durch eine Vorschubeinheit 17 der Endrolle 18 zugeführt. Vor der Weiterverarbeitung des Folienverbundes 3, beispielsweise zu IC-Karten-Modulen, muß lediglich das erste Stück des Folienverbundes 3 in einem Abstand, der dem Abstand zwischen der Abtastvorrichtung 10 und dem Stanzwerkzeug 11 entspricht, abgeschnitten und verworfen werden. Diese Länge beträgt in dem gewählten Beispiel etwa 0,5 m und ist bei möglichen Längen des Folienverbundes 3 von 100 bis 200 m nahezu vernachlässigbar klein.

## Patentansprüche

1. Verfahren zur Herstellung eines eine Metallfolienbahn und eine zweite Folienbahn enthaltenden Folienverbundes, bei dem die beiden Folienbahnen (1;2) jeweils sich in Längsrichtung der Folienbahn (1;2) in gleichmäßigen Abständen wiederholende und an aneinanderliegenden Stellen im Folienverbund angeordnete Stanzstrukturen (5) aufweisen, wobei eine vorgestanzte Folienbahn (1) und die zweite Folienbahn (2) von jeweils einem Ende her fortlaufend zusammengefügt werden, wobei nach dem Aneinanderführen der Folienbahnen (1;2) die Lage von Positionsmarkierungen (6) der an der zweiten Folienbahn (2) anliegenden Stanzstrukturen (5) der vorgestanzten Folienbahn (1) nacheinander abgetastet wird und nach Erreichen einer vorbestimmten Position der Positionsmarkierungen (6) eine Stanzstruktur (5) in den vor dem Ort des Aneinanderführens gelegenen Bereich der zweiten Folienbahn (2) in einem Abstand von der vorbestimmten Position eingebracht wird, der einem ganzzahlig Vielfachen des Abstandes entspricht, in dem sich die Stanzstrukturen (5) in der vorgestanzten Folienbahn (1) wiederholen, dadurch gekennzeichnet, daß die vorgestanzte Folienbahn (1) aus Metall und die zweite Folienbahn (2) aus Kunststoff ist und daß die Kunststoff-Folienbahn (2) vor dem Zusammenfügen mindestens teilweise mit Positionsmarkierungen (6) versehen wird und daß beim Abtasten die Positionsmarkierungen (6) der Folienbahnen (1,2) übereinander angeordnet sind.

2. Verfahren nach Anspruch 1, dadurch gekennzeichnet, daß die Positionsmarkierungen (6) der Kunststoff-Folienbahn (2) gestanzt werden.

3. Verfahren nach Anspruch 1 oder 2, dadurch gekennzeichnet, daß die Folienbahnen nach dem Abtasten miteinander verklebt werden.

4. Verfahren nach Anspruch 3, dadurch gekennzeichnet, daß die Folienbahnen nach dem Abtasten in einem ersten Schritt mittels mehrerer kleinflächiger Klebepunkte aneinandergeheftet werden und in einem zweiten Schritt großflächig miteinander verklebt werden.

5. Verfahren nach einem der Ansprüche 1 bis 4, dadurch gekennzeichnet, daß nach dem Aneinanderführen der Folienbahnen die Lage der Stanzstrukturen (5) der Folienbahnen optisch überwacht werden und daß bei Überschreiten einer vorbestimmten Abweichung der Lage der Stanzstrukturen (5) der Kunststoff-Folienbahn (2) von der Lage der Stanzstrukturen (5) der Metallfolienbahn (1) der Abstand zwischen der abgetasteten vorbestimmten Position und dem Stanzwerkzeug (11) für die Kunststoff-Folienbahn (2) korrigiert wird.

6. Verfahren nach einem der Ansprüche 1 bis 5, dadurch gekennzeichnet, daß die Positionsmarkierungen (6) kreisförmig sind.

7. Verfahren nach Anspruch 6, dadurch gekennzeichnet, daß die Abtastung mittels eines Dorns erfolgt.

8. Verfahren nach Anspruch 7, dadurch gekennzeichnet, daß die Form des Dorns der Form der Positionsmarkierungen (6) angepaßt ist.

9. Vorrichtung zur Herstellung eines eine Metallfolienbahn und eine Kunststoff-Folienbahn aufweisenden Folienverbundes (3) mit sich in gleichmäßigen Abständen wiederholenden Stanzstrukturen (5), die eine Vorschub- und Führungseinrichtung (8) für den Folienverbund (3), eine Fügevorrichtung (14) zum festen Verbinden der beiden Folienbahnen (1;2) und Vorschub- und Führungseinrichtungen (7;8) für das Aneinanderführen und das Zusammenfügen der beiden Folienbahnen (1;2) aufweist, wobei hinter dem Ort des Aneinanderführens der beiden Folienbahnen (1;2) eine Abtastvorrichtung (10) zur Erfassung der Position der Stanzstruktur (5) einer vorgestanzten Folienbahn (1) angeordnet ist, wobei der Abstand der Abtastvorrichtung (10) von dem Stanzwerkzeug (11) einem ganzzahlig Vielfachen des Abstandes entspricht, in dem sich die Stanzstrukturen (5) der vorgestanzten Folienbahn (1) wiederholen, dadurch gekennzeichnet, daß diese Abtastvorrichtung (10) mit einem Auslöser eines vor dem Ort des Aneinanderführens der beiden Folienbahnen (1;2) angeordneten Stanzwerkzeuges (11) gekoppelt ist.

10. Vorrichtung nach Anspruch 9, dadurch gekennzeichnet, daß die Abtastvorrichtung (10) eine Vorschubeinrichtung aufweist.

11. Vorrichtung nach Anspruch 9 oder 10, dadurch gekennzeichnet, daß zwischen dem Ort des Aneinanderführens der beiden Folienbahnen und der Abtastvorrichtung (10) ein Monitor (9) zur optischen Kontrolle der Stanzstrukturen (5) angeordnet ist.

12. Vorrichtung nach Anspruch 11, dadurch gekennzeichnet, daß der Monitor (9) eine Einrichtung zur meßtechnischen Erfassung von Abweichungen zwischen der Lage der Stanzstrukturen (5) der Metallfolienbahn (1) und der Kunststoff-Folienbahn (2) aufweist.

13. Vorrichtung nach einem der Ansprüche 9 bis 12, dadurch gekennzeichnet, daß das Stanzwerkzeug (11) eine Justiereinrichtung aufweist.

14. Vorrichtung nach Anspruch 13, dadurch gekennzeichnet, daß das Stanzwerkzeug (11) in x- und y-Richtung justierbar ist.

15. Vorrichtung nach einem der Ansprüche 11 bis 14, dadurch gekennzeichnet, daß der Monitor (9) mit der Justiereinrichtung des Stanzwerkzeuges (11) verbunden ist.

16. Vorrichtung nach einem der Ansprüche 9 bis 15, dadurch gekennzeichnet, daß die Abtastvorrichtung (10) einen Dorn als Abtastelement enthält.

## Claims

1. A method for the production of a composite foil containing a metal foil width and a second foil width, in which the two foil widths (1;2) respectively have punched structures (5) repeating themselves at regular intervals in longitudinal direction of the foil width (1;2) and arranged at adjacent sites in the composite foil, in which a pre-punched foil width (1) and the second foil width (2) are joined together continuously from the direction of one end respectively, in which after the guiding to each other of the foil widths (1;2), the location of position markings (6) of the punched structures (5) of the pre-punched foil width (1), lying on the second foil width (2), is scanned in succession and after reaching a predetermined position of the position markings (6), a punched structure (5) is introduced into the region of the second foil width (2), situated before the site of guiding to each other, at a distance from the predetermined position, which corresponds to an integral multiple of the interval in which the punched structures (5) repeat themselves in the pre-punched foil width (1), characterised in that the pre-punched foil width (1) is of metal and the second foil width (2) is of plastic and that the plastic foil width (2), before joining together, is provided at least partially with position markings (6) and that on scanning, the position markings (6) of the foil width (1, 2) are arranged one over the other.

2. A method according to Claim 1, characterised in that the position markings (6) of the plastic foil width (2) are punched.

3. A method according to Claim 1 or 2, characterised in that the foil widths are glued to each other after scanning.

4. A method according to Claim 3, characterised in that the foil widths, after scanning, are fastened to each other in a first step by means of several adhesive points covering a small area, and in a second step are glued to each other over a large area.

5. A method according to one of Claims 1 to 4, characterised in that after guiding the foil widths to each other, the position of the punched structures (5) of the foil widths is monitored optically and that on exceeding a predetermined deviation of the position of the punched structures (5) of the plastic foil width (2) from the position of the punched structures (5) of the metal foil width (1), the distance between the scanned predetermined position and the punching tool (11) for the plastic foil width (2) is corrected.

6. A method according to one of Claims 1 to 5, characterised in that the position markings (6) are circular.

7. A method according to Claim 6, characterised in that the scanning takes place by means of a pin.

8. A method according to Claim 7, characterised in that the shape of the pin is adapted to the shape of the position markings (6).

9. Apparatus for the production of a composite foil (3) having a metal foil width and a plastic foil width, with punched structures (5) repeating themselves at regular intervals, which has a feeding- and guiding arrangement (8) for the composite foil (3), a joining device (14) for the secure connecting of the two foil widths (1;2) and feeding-and guiding arrangements (7;8) for the guiding to each other and joining together of the two foil widths (1;2), in which behind the site of guiding of the two foil widths (1;2) to each other, a scanning device (10) is arranged to detect the position of the punched structure (5) of a pre-punched foil width (1), in which the distance of the scanning device (10) from the punching tool (11) corresponds to an integral multiple of the interval at which the punched structures (5) of the pre-punched foil width (1) repeat themselves, characterised in that this scanning device (10) is coupled with a trigger of a punching tool (11) arranged before the site of guiding the two foil widths (1;2) to each other.

10. Apparatus according to Claim 9, characterised in that the scanning device (10) has a feeding arrangement.

11. Apparatus according to Claim 9 or 10, characterised in that between the site of guiding the two foil widths to each other and the scanning device (10), a monitor (9) is arranged for the optical monitoring of the punched structures (5).

12. Apparatus according to Claim 11, characterised in that the monitor (9) has an arrangement for detecting by measurement technology deviations between the position of the punched structures (5) of the metal foil width (1) and of the plastic foil width (2).

13. Apparatus according to one of Claims 9 to 12, characterised in that the punching tool (11) has an adjusting arrangement.

14. Apparatus according to Claim 13, characterised in that the punching tool (11) is adjustable in x- and y-direction.

15. Apparatus according to one of Claims 11 to 14, characterised in that the monitor (9) is connected with the adjusting arrangement of the punching tool (11).

16. Apparatus according to one of Claims 9 to 15, characterised in that the scanning device (1) contains a pin as scanning element.

## Revendications

1. Procédé pour produire un composite de film comportant une bande de film métallique et une seconde bande de film, dans lequel les deux bandes de film (1 ; 2) présentent des structures poinçonnées (5) qui se répètent en direction longitudinale de la bande de film (1 ; 2) à des distances régulières et qui sont prévues à des emplacements situés les uns contre les autres dans le composite de film, dans lequel on assemble en continu depuis une extrémité respective une bande de film (1) prépoinçonnée et la seconde bande de film (2), dans lequel, après avoir regroupé les bandes de film (1 ; 2), on détecte successivement la position de marquages de position (6) des structures poinçonnées (5), en contact avec la seconde bande de film (2), de la bande de film (1) prépoinçonnée, et après avoir atteint une position prédéterminée des marquages de position (6), on ménage une structure poinçonnée (5) dans cette région de la seconde bande de film (2) qui se trouve en avant de l'endroit de regroupement, à une distance de la position prédéterminée qui correspond à un multiple entier de la distance à laquelle se répètent les structures poinçonnées (5) dans la bande de film (1) prépoinçonnée, caractérisé en ce que la bande de film (1) prépoinçonnée est en métal et la seconde bande de film (2) est en matière plastique, et en ce que la bande de film en matière plastique (2) est pourvue au moins partiellement de marquages de position (6) avant l'assemblage, et en ce que les marquages de position (6) des bandes de film (1, 2) sont agencés les uns aux dessus des autres pendant la détection.

2. Procédé selon la revendication 1, caractérise en ce que les marquages de position (6) de la bande de film en matière plastique (2) sont poinçonnés.

3. Procédé selon l'une ou l'autre des revendications 1 et 2, caractérisé en ce que les bandes de film sont collées l'une avec l'autre après la détection.

4. Procédé selon la revendication 3, caractérise en ce que les bandes de film sont pointées l'une contre l'autre dans une première opération après la détection au moyen de plusieurs points de colle de petite surface, et en ce qu'elles sont collées sur une grande surface dans une seconde opération.

5. Procédé selon l'une quelconque des revendications 1 à 4, caractérisé en ce qu'après le regroupement des bandes de film, on surveille par voie optique la position des structures poinçonnées (5) des bandes de film, et en ce que lors du dépassement d'un écart prédéterminé de la position des structures poinçonnées (5) de la bande de film en matière plastique (2) par rapport à la position des structures poinçonnées (5) de la bande de film métallique (1), on corrige la distance entre la position détectée prédéterminée et l'outil de poinçonnage (11) pour la bande de film en matière plastique (2).

6. Procédé selon l'une quelconque des revendications 1 à 5, caractérisé en ce que les marquages de position (6) sont circulaires.

7. Procédé selon la revendication 6, caractérisé en ce que la détection s'effectue au moyen d'un doigt.

8. Procédé selon la revendication 7, caractérisé en ce que la forme du doigt est adaptée à la forme des marquages de position (6).

9. Dispositif pour produire un composite de film (3) présentant une bande de film métallique et une bande de film en matière plastique et comportant des structures poinçonnées (5) qui se répètent à des distances régulières, lequel comprend un dispositif d'avance et de guidage (8) pour le composite de film (3), un dispositif d'assemblage (14) pour la liaison ferme des deux bandes de film (1 ; 2) et des dispositifs d'avance et de guidage (7 ; 8) pour le regroupement et l'assemblage des deux bandes de film (1 ; 2), dans lequel un dispositif de détection (10) pour détecter la position de la structure poinçonnée (5) d'une bande de film (1) prépoinçonnée est agencé derrière l'endroit du regroupement des deux bandes de film (1 ; 2), dans lequel la distance entre le dispositif de détection (10) et l'outil de poinçonnage (11) correspond à un multiple entier de la distance à laquelle se répètent les structures poinçonnées (5) de la bande de film prépoinçonnée (1), caractérisé en ce que ce dispositif de détection (10) est couplé à un déclencheur pour un outil de poinçonnage (11) agencé en avant de l'endroit du regroupement des deux bandes de film (1 ; 2).

10. Dispositif selon la revendication 9, caractérisé en ce que le dispositif de détection (10) comprend un dispositif d'avance.

11. Dispositif selon l'une ou l'autre des revendications 9 et 10, caractérisé en ce qu'il est prévu entre l'endroit du regroupement des deux bandes de film et le dispositif de détection (10) un moniteur (9) pour le contrôle optique des structures poinçonnées (5).

12. Dispositif selon la revendication 11, caractérisé en ce que le moniteur (9) comprend un dispositif de métrologie pour détecter des écarts entre la position des structures poinçonnées (5) de la bande de film métallique (1) et de la bande de film en matière plastique (2).

13. Dispositif selon l'une quelconque des revendications 9 à 12, caractérisé en ce que l'outil de poinçonnage (11) comprend un dispositif d'ajustage.

14. Dispositif selon la revendication 13, caractérisé en ce que l'outil de poinçonnage (11) est ajustable en direction X et en direction Y.

15. Dispositif selon l'une quelconque des revendications 11 à 14, caractérisé en ce que le moniteur (9) est relié au dispositif d'ajustage de l'outil de poinçonnage (11).

16. Dispositif selon l'une quelconque des revendications 9 à 15, caractérisé en ce que le dispositif de détection (10) comporte un doigt en tant qu'élément de détection.
